# EUROPEAN PATENT APPLICATION

(11) **EP 4 826 927 A1**
(43) Date of publication of application: **21.10.2026**
(21) Application number: 24903701.1
(22) Date of filing: 11.12.2024
(51) Int. Cl.: H01S 5/02208, A61B 18/24, H01S 5/0225, H01S 5/0233, H01S 5/024

(54) **LIGHT IRRADIATION DEVICE AND IN-VIVO LIGHT IRRADIATION ASSEMBLY USING SAME**

(30) Priority: 15.12.2023 JP 2023211660
(71) Applicant: NICHIA CORPORATION, Anan-shi, Tokushima 774-8601 (JP)
(72) Inventor: MIYATA, Tadaaki, Anan-shi, Tokushima 774-8601 (JP)
(74) Representative: Betten & Resch
(86) International application number: PCT/JP2024/043718
(87) International publication number: WO 2025/127047

(57) **Abstract**

A small light irradiation device having heat dissipation and electrical insulation properties will be provided. The light irradiation device includes: a light-emitting element having a first surface from which light having a predetermined wavelength is emitted; a support body on which the light-emitting element is mounted; a first insulating layer covering at least a part of the light-emitting element except for the first surface; an insulated wire electrically connected to the light-emitting element in a region excluding the first surface; and a case in which the first surface is sealed within a first space.

## Description

### Technical Field

The present disclosure relates to a light irradiation device and an in-vivo light irradiation assembly using the same.

### Background Art

Endoscopes are used for diagnoses and treatments in a biological body. An endoscope to be inserted into a body cavity to observe an affected area has a configuration in which irradiation light is introduced by an optical fiber, or a configuration in which a light-emitting element (LED) that emits illumination light is attached to a tip end portion of the endoscope. As the latter configuration, a configuration has been proposed in which a part of an exterior tube is used as a heat dissipation member in order to improve the heat dissipation from a light-emitting element in an endoscope and to reduce the size of the tip end portion (for example, see Patent Document 1). In this endoscope, a flexible printed circuit board on which a plurality of light-emitting elements (LEDs) are disposed in a line is rolled into a cylindrical shape and inserted into an exterior tube, and heat from the LEDs is released from the flexible printed circuit board to the exterior tube.

Light introduced into a biological body includes light for treatment in addition to illumination light of an endoscope. In photoimmunotherapy that has been recently attracting attention, when an affected area is on the body surface or in a shallow region from the body surface, the body surface is irradiated with light having a specific wavelength that reacts with a photosensitizer accumulated in cancer cells. When the affected area is located at a deep position from the body surface, the affected area in the body is irradiated with laser light by puncturing. An optical fiber is inserted into a blood vessel, a digestive tract, or other lumen, and the affected area in the biological body is irradiated with laser light having a specific wavelength from a light source outside the biological body.

### Citation List

### Patent Literature

Patent Document 1: JP 2008-272298 A

### SUMMARY OF INVENTION

### Technical Problem

The configuration using the optical fiber for laser irradiation inside the biological body is weak against bending, and optical loss increases in proportion to the length of the optical fiber. An ultra-small light source that can be inserted into the vicinity of an affected area in a body without an optical fiber is desired. One aspect of the present disclosure provides a small light irradiation device having heat dissipation and electrical insulation properties.

### Solution to Problem

In one embodiment, a light irradiation device includes: a light-emitting element having a first surface from which light having a predetermined wavelength is emitted; a support body on which the light-emitting element is mounted; a first insulating layer covering at least a part of the light-emitting element except for the first surface; an insulated wire electrically connected to the light-emitting element in a region excluding the first surface; and a case in which the first surface is sealed within a first space. Advantageous Effects of Invention

A small light irradiation device having heat dissipation and electrical insulation properties is realized.

### BRIEF DESCRIPTION OF DRAWINGS

FIG. 1 is a diagram illustrating an example of an in-vivo light irradiation assembly using a light irradiation device of a first embodiment.
FIG. 2A is a schematic view illustrating a configuration example of a light irradiation device.
FIG. 2B is a schematic view of a modified example of a light irradiation device.
FIG. 3 is a side view illustrating the appearance of a light-emitting element mounting portion of the light irradiation device.
FIG. 4 is a schematic view illustrating a configuration example of an optical component.
FIG. 5 is a schematic view of another modified example of the light irradiation device.
FIG. 6 is a schematic view of a light irradiation device of a second embodiment.
FIG. 7 is a schematic view of a light irradiation device of a third embodiment.

### DESCRIPTION OF EMBODIMENTS

Hereinafter, an embodiment for carrying out the present disclosure is described with reference to the drawings. The following description is intended to embody technical concepts of the present disclosure, and the present disclosure is not limited to the following unless specifically stated. In each drawing, members having identical functions may be denoted by the same reference characters. In view of the ease of explanation or understanding of the points, the embodiments may be illustrated separately for convenience, but the partial substitutions or combinations of the configurations illustrated in different embodiments and examples are possible. In the embodiments to be described below, differences from the embodiment described before are mainly described, and redundant descriptions of commonalities with the embodiment described before are sometimes omitted. The size, positional relationship, and other features of members illustrated in the drawings may be exaggerated in order to clarify explanation.

### First Embodiment

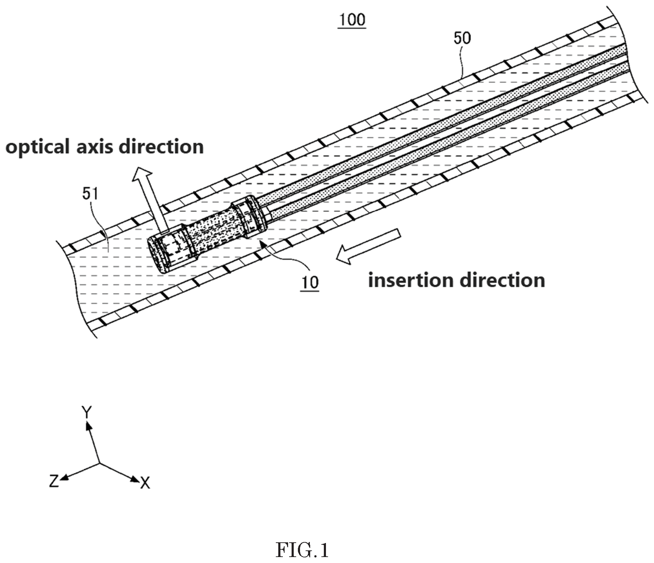

FIG. 1 is a diagram illustrating an example of an in-vivo light irradiation assembly 100 using a light irradiation device 10 of a first embodiment. The in-vivo light irradiation assembly 100 includes a catheter 50 and the light irradiation device 10 inserted into the catheter 50, and the inside of the catheter 50 is filled with a coolant 51 at least during use. The in-vivo light irradiation assembly 100 is used for treatment, diagnosis, sensing, and the like. The light irradiation device 10 is inserted into the catheter 50 in an "insertion direction" indicated by a white arrow in the drawing, for example, and is introduced into a biological body. Because the light irradiation device 10 is a heat generating element, the light irradiation device 10 is used in a state in which the coolant 51 is supplied into the catheter 50 and a heat generating portion is cooled. The coolant 51 is, for example, physiological saline, blood, lymph, or the like, and the coolant temperature is, for example, in a range of about 10 °C to 36 °C. Because the light irradiation device 10 is inserted into the vicinity of a target site such as an affected area in the biological body by using the catheter 50, the affected area such as a tumor can be directly irradiated with light without using an optical fiber, or the target site for diagnosis, sensing, or the like can be examined and confirmed.

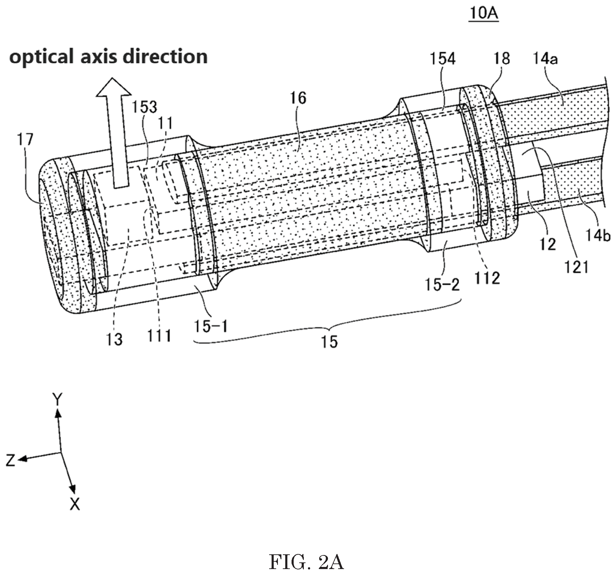

FIG. 2A is a schematic view of a light irradiation device 10A as one of the configuration examples of the light irradiation device 10. The light irradiation device 10A includes a light-emitting element 11 that emits light having a predetermined wavelength, a support body 12 on which the light-emitting element 11 is mounted, a first insulating layer 16 covering at least a part of the light-emitting element 11, insulated wires 14a and 14b electrically connected to the light-emitting element 11, and a case 15. In the first embodiment, the case 15 includes a first case portion 15-1 and a second case portion 15-2, but as described below, the case 15 is not necessarily formed of two case portions separate from each other, and does not necessarily include the second case portion. The light-emitting element 11 has a first surface 111 from which light having a specific wavelength is emitted, and a second surface 112 on the side opposite to the first surface 111. The first insulating layer 16 is, for example, an insulating resin layer, and covers a part of the light-emitting element 11 except for the first surface 111. The insulated wires 14a and 14b are electrically connected to the light-emitting element 11 in a region excluding the first surface 111. The first case portion 15-1 seals the first surface 111 of the light-emitting element 11 within a first space 153, and the second case portion 15-2 seals the second surface 112 of the light-emitting element 11 within a second space 154. At least a portion of the case 15, from which light emitted from the first surface 111 of the light-emitting element 11 is extracted to the outside, is light transmissive.

The light-emitting element 11 is held on the support body 12 so that the first surface 111 as a light-emitting surface and the second surface 112 as a reflective surface do not interfere with other components. In the coordinate system of FIG. 2A, an optical axis direction of the light-emitting element 11 is defined as a Z direction, a direction in which the light-emitting element 11 is mounted on the support body 12 is defined as a Y direction, and a direction orthogonal to the Z direction and the Y direction is defined as an X direction. The longitudinal direction of the support body 12 is parallel to the Z direction. The light irradiation device 10A is inserted into the catheter 50 in the + Z direction. The insulated wires 14a and 14b extend in the - Z direction. The support body 12 is made of an insulating material such as silicon (Si), aluminum nitride (AlN), silicon nitride (SiN), sapphire (Al₂O₃), glass, quartz, or ceramic. The light-emitting element 11 is disposed on a light-emitting element mounting surface 121 of the support body 12.

The first insulating layer 16 integrally covers at least a part of the light-emitting element 11 except for the first surface 111 and the second surface 112, an electrical connection portion between the light-emitting element 11 and the insulated wire 14a and an electrical connection portion between the light-emitting element 11 and the insulated wire 14b, and a part of the support body 12. The first insulating layer 16 is preferably an electrically insulating resin having high thermal conductivity. The first insulating layer 16 seals the layered portion of the support body 12, the light-emitting element 11, and the insulated wires 14a and 14b so that the coolant 51 does not enter the first space 153 and the second space 154, and also is in contact with the coolant 51 on its outer surface through which heat from the light-emitting element 11 is released.

In the first embodiment, the case 15 includes the first case portion 15-1 sealing the first surface 111 of the light-emitting element 11 within the first space 153, and the second case portion 15-2 sealing the second surface 112 of the light-emitting element 11 within the second space 154. A tip end portion of the first case portion 15-1 on the + z side is sealed with a second insulating layer 17. A rear end portion of the second case portion 15-2 on the - z side is sealed with a third insulating layer 18.

The second insulating layer 17 and the third insulating layer 18 may be made of a different type of resin from that of the first insulating layer 16. For example, the second insulating layer 17 and the third insulating layer 18 are made of a resin material having a higher viscosity than the first insulating layer 16. The first insulating layer 16 covers a relatively wide portion between the first case portion 15-1 and the second case portion 15-2, and thus allows resin-sealing relatively easily. In contrast, the second insulating layer 17 and the third insulating layer 18 seal, with resin, a minute region, that is, an opening portion at the tip end of the first case portion 15-1 and an opening portion at the rear end of the second case portion 15-2. The viscosity of the second insulating layer 17 and the third insulating layer 18 is made higher than that of the first insulating layer 16, and the opening portion at the tip end of the first case portion 15-1 and the opening portion at the rear end of the second case portion 15-2 are reliably sealed, thereby preventing the coolant from entering the first space 153 and the second space 154.

The rear end portion of the first case portion 15-1 on the - z side is sealed by the first insulating layer 16, and the first surface 111 of the light-emitting element 11 is exposed within the first space 153 in a region between the first insulating layer 16 and the second insulating layer 17. The tip end portion of the second case portion 15-2 on the + z side is sealed by the first insulating layer 16, and the second surface 112 of the light-emitting element 11 is exposed within the second space 154 in the region between the first insulating layer 16 and the third insulating layer 18. The first insulating layer 16, the second insulating layer 17, and the third insulating layer 18 are all insulating resin sealing materials even though wettability and the viscosity are different. The wettability and the viscosity may be adjusted by adding a surface adjusting agent to an epoxy resin, a silicone resin, an acrylic resin, a thermoplastic resin, or the like.

More preferably, the first insulating layer 16, the second insulating layer 17, and the third insulating layer 18 are made of a biocompatible insulating resin having high thermal conductivity. As the resin material, polycarbonate (PC), polyethylene terephthalate (PET), polyimide (PI), polyurethane, polyester imide, or the like, whose components and composition are adjusted to mitigate adverse effects on a biological body, can be used. In addition, a coat formed by applying a polysilazane solution and turning the polysilazane solution into silica (hereinafter, referred to as a polysilazane coat) can be used. When the polysilazane coat is used for the first insulating layer 16, an additional resin for sealing the rear end of the first case portion 15-1, and an additional resin for sealing the tip end of the second case portion 15-2 may be provided in addition to the polysilazane coat. These additional resins may be the same as or different from the resins used for the second insulating layer 17 and the third insulating layer 18. The light irradiation device 10A may be coated in its entirety with the polysilazane coat.

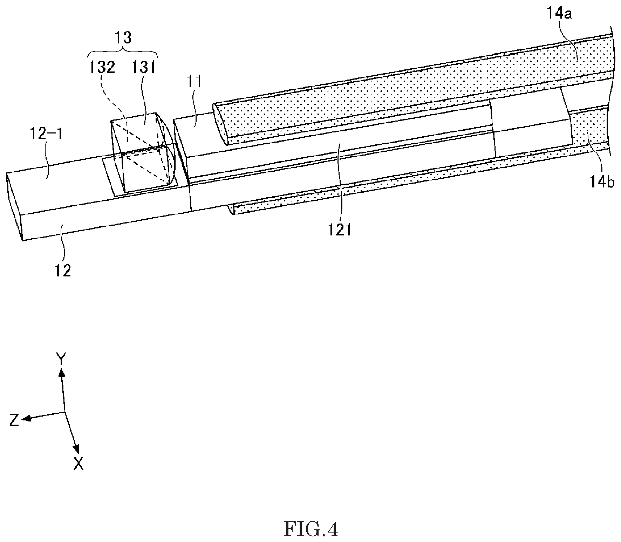

Inside the first case portion 15-1, an optical component 13 facing the first surface 111 of the light-emitting element 11 is disposed on the support body 12. The optical component 13 causes light emitted from the light-emitting element 11 to travel to the outside of the first case portion 15-1. The optical component 13 is a mirror or prism flattened to be thin. As the optical component 13, a meta-polarization element having a thin metasurface element inserted therein may be used. The optical component 13 may be an optical element having a lens function of controlling the divergence angle of the light emitted from the light-emitting element 11. The optical component 13 may include two or more optical elements as described below with reference to FIG. 4. For example, the optical component 13 may include an optical element having a lens function of controlling the divergence angle of the light emitted from the light-emitting element 11, and an optical element that reflects, at a predetermined angle, the light whose divergence angle has been controlled by the optical element.

At least a portion of the first case portion 15-1, from which light is extracted from the optical component 13 to the outside, is made of a light transmissive material. In FIG. 2A, the light emitted from the first surface 111 of the light-emitting element 11 in the + Z direction is emitted in the + Y direction via the optical component 13; however, the direction of light to be emitted is not limited to this example. As long as the light can be emitted to the outside of the first case portion 15-1 without being obstructed by the second insulating layer 17 or the light-emitting element mounting surface 121 of the support body 12, the light may be emitted in any direction between the - X direction and the + X direction on the XY plane. In addition, the light may be emitted at an angle inclined in the + Z direction or the - Z direction from the normal line to the light-emitting element mounting surface 121 of the support body 12 as long as the light is not obstructed by the second insulating layer 17 or the light-emitting element 11.

The first case portion 15-1 and the second case portion 15-2 may be transparent cylindrical bodies made of glass, quartz, biocompatible plastic, or the like. The outer diameters of the first case portion 15-1 and the second case portion 15-2 are, for example, in a range from 0.4 mm to 2.0 mm. The inner diameters thereof are in a range from 0.3 mm to 1.5 mm. As an example, a biocompatible plastic tube with an outer shape of 0.5 mm and an inner diameter of 0.38 mm is used. The lengths of the first case portion 15-1 and the second case portion 15-2 in the Z direction may be the same as or different from each other. In FIG. 2A, since the optical component 13 is disposed in the first space 153, the length of the first case portion 15-1 in the Z direction is greater than the length of the second case portion 15-2 in the Z direction.

The support body 12 on which the light-emitting element 11 is mounted protrudes outward from at least one of the first case portion 15-1 or the second case portion 15-2. In the configuration of FIG. 2A, the support body 12 protrudes from the rear end of the second case portion 15-2. The support body 12 is located between the insulated wires 14a and 14b in the Y direction, and protrudes in the - Z direction from the third insulating layer 18 at the rear end of the second case portion 15-2 together with the insulated wires 14a and 14b. The insulated wires 14a and 14b and the support body 12 are in contact with the coolant, and function as a heat dissipation material through which heat is released from the light-emitting element 11 to the outside.

The width of the support body 12 in the X direction is smaller than the inner diameters of the first case portion 15-1 and the second case portion 15-2, but may be set as wide as possible within a range in which the support body 12 can be accommodated in the first case portion 15-1 and the second case portion 15-2 from the viewpoint of increasing the contact area with the coolant 51. The thickness of the support body 12 in the Y direction is a thickness that allows the support body 12 to stably support the light-emitting element 11, and is, for example, 0.1 mm.

The insulated wires 14a and 14b extending from the rear end of the second case portion 15-2 in the - Z direction are, for example, enameled wires. A metal wire of a good conductor such as Cu or Ni is insulation-coated with an insulating coating of polyurethane. Instead of polyurethane, coating of polyester, polyesterimide, polyamideimide, polyimide, or the like, which is an insulating resin, may be applied. By using the insulating coating, which is the surface coating on the insulated wires 14a and 14b, as a heat dissipation material, heat from the light-emitting element 11 is released. When rectangular enameled wires are used as the insulated wires 14a and 14b, the wires are wide wires, and a joint area with the support body 12 can be increased. In addition, when the cross-sectional area is the same, the rectangular enameled wire can be made thinner than a round enameled wire, and thus can be made smaller in size.

As described above, the light irradiation device 10A has a configuration having heat dissipation and electrical insulation properties. The first surface 111 and the second surface 112 of the light-emitting element 11 are held in the first space 153 and the second space 154 sealed in the first case portion 15-1 and the second case portion 15-2 so as not to interfere with other components. At least a part of the light-emitting element 11 is sealed with the first insulating layer 16 except for the first surface 111 and the second surface. This allows the light irradiation device 10A to reduce its overall size, and thus facilitates insertion of the light irradiation device 10A into the catheter 50.

### Modified Example of Light Irradiation Device

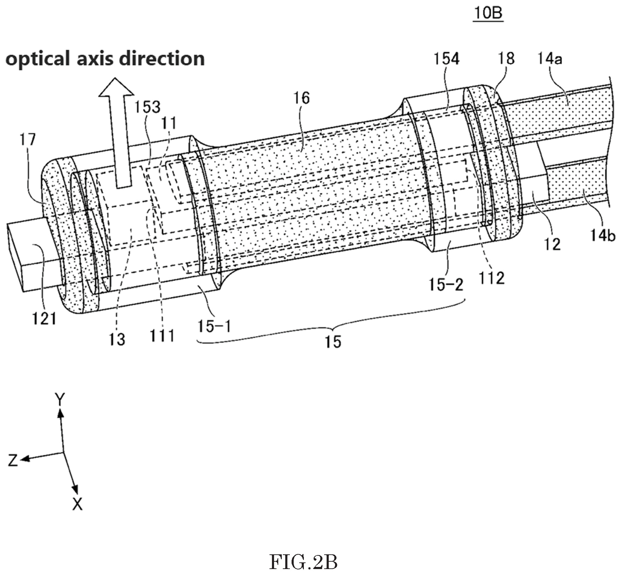

FIG. 2B is a schematic view of a light irradiation device 10B according to a modified example of the light irradiation device 10A. In the light irradiation device 10B, the support body 12 protrudes from the tip end of the first case portion 15-1 in the + Z direction, and protrudes from the rear end of the second case portion 15-2 in the - XZ direction. The opening on the tip end side of the first case portion 15-1 is sealed with the second insulating layer 17 such that the support body 12 protrudes outward from it. The opening on the rear end side of the second case portion 15-2 is sealed with the third insulating layer 18 such that the support body 12 protrudes outward from it.

Similarly to the light irradiation device 10A, the rear end portion of the first case portion 15-1 is sealed with the first insulating layer 16, and the first surface 111 of the light-emitting element 11 is exposed within the first space 153 in the region between the first insulating layer 16 and the second insulating layer 17. The tip end portion of the second case portion 15-2 is sealed with the first insulating layer 16, and the second surface 112 of the light-emitting element 11 is exposed within the second space 154 in a region between the first insulating layer 16 and the third insulating layer 18. At least a part of the light-emitting element 11 is integrally sealed together with the support body 12 and the insulated wires 14a and 14b except for the first surface 111 and the second surface 112 by the first insulating layer 16 in a region between the first case portion 15-1 and the second case portion 15-2. The first insulating layer 16 isolates the electrical connection portion between the light-emitting element 11 and the insulated wire 14a and the electrical connection portion between the light-emitting element 11 and the insulated wire 14b from the coolant 51, and functions as a heat dissipation material through which heat from the light-emitting element 11 is released to the outside.

In the light irradiation device 10B, the support body 12 protrudes from both the first case portion 15-1 and the second case portion 15-2, thereby further enhancing the heat dissipation property compared to the light irradiation device 10A. In addition, by sealing the region between the first case portion 15-1 and the second case portion 15-2 with the first insulating layer 16, the overall size of the light irradiation device 10B can be reduced. The light irradiation device 10B that has heat dissipation and electrical insulation properties and can be incorporated into a catheter is realized.

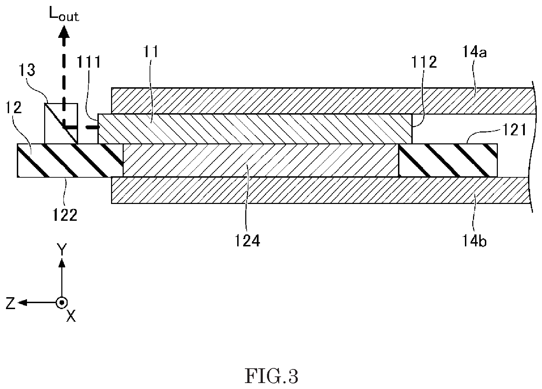

FIG. 3 is a side view illustrating the appearance of the light-emitting element mounting portion of the light irradiation device 10A in FIG. 2A or the light irradiation device 10B in FIG. 2B. The configuration of FIG. 3 illustrates the light-emitting element mounting portion in a state before being sealed with the first insulating layer 16, the second insulating layer 17, and the third insulating layer 18, with the first surface 111 and the second surface 112 of the light-emitting element 11 exposed within the first space 153 of the first case portion 15-1 and the second space 154 of the second case portion 15-2, respectively.

The light-emitting element 11 is, for example, an edge-emitting laser element, and resonates in a direction parallel to a Z axis. The light-emitting element 11 is disposed on the support body 12 so that the first surface 111, which is a light-emitting surface, faces the optical component 13. The second surface 112, which is the rear end surface of the light-emitting element 11, is a reflective surface, and a highly reflective film may be formed thereon. A laser cavity is formed between the first surface 111 and the second surface 112.

The optical component 13 guides light emitted from the first surface 111 of the light-emitting element 11 in a desired direction. In FIG. 3, output light Lout is guided in the + Y direction by the optical component 13, but the output light Lout may be guided in any direction as long as the light emitted from the light-emitting element 11 can be extracted from the first case portion 15-1 to the outside without being obstructed by the second insulating layer 17 or the support body 12.

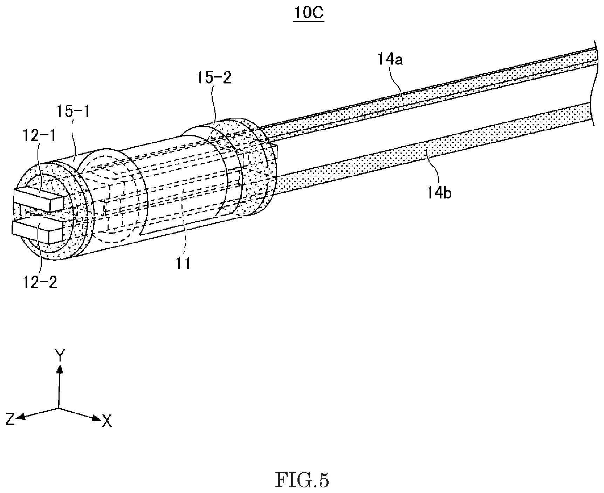

The insulated wires 14a and 14b do not hinder the light output of the edge-emitting laser element. A part of the insulating coating on the insulated wire 14a is removed, and the inside metal wire is electrically connected directly or indirectly to one of the electrodes of the light-emitting element 11. A part of the insulating coating on the insulated wire 14b is removed, and the inside metal wire is electrically connected to the other electrode of the light-emitting element 11. In the example of FIG. 3, the conductive film 124 is formed from the light-emitting element mounting surface 121 of the support body 12 to the back surface 122 through the lateral surface, and the metal wire inside the insulated wire 14b is connected to the conductive film 124. This provides electrical connection between the other electrode of the light-emitting element 11 and the insulated wire 14b. By providing the conductive film 124 for electrical connection on the surface of the support body 12, the conductive film 124 together with the first insulating layer 16 can be used as a heat dissipation member. As described below with reference to FIG. 5, a second support body may be disposed between the insulated wire 14a and the light-emitting element 11. The heat dissipation property can be improved by arranging the light-emitting element 11 between the support body 12 and the second support body.

The semiconductor materials of the light-emitting element 11 and their composition are designed to emit laser light having a desired wavelength. When the light-emitting element 11 is used as an ultraviolet laser, a violet laser, a blue laser, and a green laser, a GaN-based material such as GaN, InGaN, and AlGaN is used. When the light-emitting element 11 is used as a red laser, an infrared laser, and a near-infrared laser, a GaAs-based material such as GaAs or AlGaAs or an InP-based material such as InAlGaP or GaInP is used. In order that the light irradiation device 10A or 10B has a shape suitable for being incorporated into the catheter 50, the resonator of the laser element may be shortened as much as possible, while the width direction may be widened to the maximum range in which the laser element can be accommodated in the first case portion 15-1 and the second case portion 15-2 to form a wide ridge, thereby ensuring the gain of an active layer. The width of the ridge may be designed to be, for example, 2 µm to 100 µm. The transverse mode may be a multi-mode or a single mode.

Unlike a fiber-type irradiation device, the light emitted by the light-emitting element 11 is linearly polarized light, and the direction of the linearly polarized light after emission can be changed by changing the reflection direction by the optical component 13 such as a mirror. This makes it possible to reduce the reflectance of light incident on a biological body and improve the transmittance of light to the biological body, for example. Laser light in a specific polarization state at the stage of being emitted may also be subjected to a change in the polarization state or may be depolarized, while passing through a transmission medium such as an optical fiber. In the present embodiment, since the affected area in the body can be directly irradiated with light without using an optical fiber, a target portion such as the affected area can be irradiated with light while maintaining a specific polarization state.

FIG. 4 is a schematic view illustrating a configuration example of the optical component 13. FIG. 4 illustrates a state before the first surface 111 and the second surface 112 of the light-emitting element 11 are accommodated in the first case portion 15-1 and the second case portion 15-2, respectively. The optical component 13 may include two or more optical elements. For example, the optical component 13 may include an optical element 131 having a lens function of controlling the divergence angle of the light emitted from the light-emitting element 11, and an optical element 132 that reflects, at a predetermined angle, the light whose divergence angle has been controlled by the optical element 131. In this configuration example, the incident surface of the optical element 131 is formed into a convex surface, but the reflective surface of the optical element 132 may be formed into a concave surface. In the example of FIG. 4, the optical element 132 reflects the light collimated by the optical element 131 in the + Y direction, but the reflection direction or the reflection angle of the optical element 132 can be designed as appropriate. The plurality of reflective optical elements 131 and 132 are integrated into a single unit, so that the overall size of the optical component 13 can be reduced, and the light irradiation device 10 can be downsized accordingly.

FIG. 5 is a schematic view of a light irradiation device 10C as still another modified example of the light irradiation device of the first embodiment. In the light irradiation device 10C, the light-emitting element 11 is arranged between a first support body 12-1 and a second support body 12-2. The first support body 12-1 is in contact with the upper surface of the light-emitting element 11, and the second support body 12-2 is in contact with the bottom surface of the light-emitting element 11. By arranging the light-emitting element 11 between the first support body 12-1 and the second support body 12-2, heat can be efficiently released to the upper side and the lower side of the light-emitting element 11, and the heat dissipation property of the light irradiation device 10 can be improved. The rear end of at least one of the first support body 12-1 or the second support body 12-2 may extend in the - Z direction and protrude rearward from the second case portion 15-2. In FIG. 5, the direction or angle of the reflective surface of the optical component 13 may be determined so that the light emitted from the light-emitting element 11 is extracted in a direction in which the light is not obstructed by the first support body 12-1 or the second support body 12-2, for example, in the + X direction or the - X direction.

The light irradiation device 10A, 10B, or 10C of the first embodiment may be used in combination with an endoscope. The light-emitting element 11 can be used not only as a laser light source for treatment, but also as an illumination light source. In any case, the light irradiation device has a heat dissipation property and an electrical insulation property, and exhibits an effect as a light irradiation device that can be incorporated into a catheter. Unlike an optical fiber, an insulated wire coated with an insulating coating is highly flexible. In addition, the configuration in which the light-emitting element itself is mounted on the support body 12 offers high integration, and has a wide range of applications for sensors.

### Second Embodiment

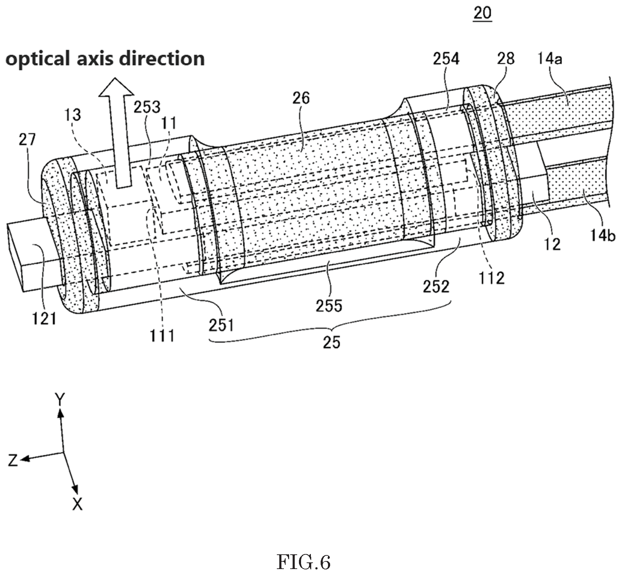

FIG. 6 is a schematic view of a light irradiation device 20 of the second embodiment. The second embodiment uses a case 25 in which a first case portion and a second case portion are connected to each other by a connecting portion. Similarly to the first embodiment, the light irradiation device 20 is inserted into the catheter 50 (see FIG. 1), and can be used while being cooled by the coolant 51. The light irradiation device 20 includes the light-emitting element 11 that emits light having a predetermined wavelength, the support body 12 on which the light-emitting element 11 is mounted, and a first insulating layer 26 having an insulation property and covering at least a part of the light-emitting element 11, insulated wires 14a and 14b electrically connected to the light-emitting element 11, and the case 25. The light-emitting element 11 has a first surface 111 from which light having a specific wavelength is emitted, and a second surface 112 on the side opposite to the first surface 111. The first insulating layer 26 covers at least a part of the light-emitting element 11 except for the first surface 111 and the second surface 112. The insulated wires 14a and 14b are electrically connected to the light-emitting element 11 in a region excluding the first surface 111.

The case 25 includes a first case portion 251 sealing the first surface 111 of the light-emitting element 11 within a first space 253, a second case portion 252 sealing the second surface 112 of the light-emitting element 11 within a second space 254, and a connecting portion 255 connecting the first case portion 251 and the second case portion 252. The first case portion 251 and the second case portion 252 have a cylindrical shape. The connecting portion 255 has a shape obtained by cutting out a cylindrical lateral surface. At least a part of the light-emitting element 11, the electrical connection portion between the light-emitting element 11 and the insulated wire 14a and the electrical connection portion between the light-emitting element 11 and the insulated wire 14b, and a part of the support body 12 are integrally covered with the first insulating layer 26 and supported by the connecting portion 255. At least a portion of the first case portion 251, from which light emitted from the first surface 111 of the light-emitting element 11 is extracted to the outside, is light transmissive.

The portion of the light-emitting element 11, which is covered with the first insulating layer 26 in a region between the first surface 111 and the second surface 112 of the light-emitting element 11 and covered integrally with the support body 12 and the insulated wires 14a and 14b, is stably supported by the connecting portion 255 of the case 25. The connecting portion 255 does not need to hold the entire circumference of the portion covered with the first insulating layer 26, but is sufficient to support a minimum necessary region of the surface of the first insulating layer 26 along the longitudinal direction (Z direction) of the support body 12. The first insulating layer 26 seals the layered portion of the support body 12, the light-emitting element 11, and the insulated wires 14a and 14b so that the coolant 51 does not enter the first space 253 or the second space 254. The first insulating layer 26 is also in contact with the coolant 51 on its outer surface through which heat from the light-emitting element 11 is released.

The first case portion 251, the second case portion 252, and the connecting portion 255 may be integrally molded with biocompatible plastic or the like. The tip end portion of the first case portion 251 on the + Z side is sealed with a second insulating layer 27. The rear end portion of the second case portion 252 on the - Z side is sealed with a third insulating layer 28. The second insulating layer 27 and the third insulating layer 28 may be made of a different type of resin from that of the first insulating layer 26. For example, the second insulating layer 27 and the third insulating layer 28 may be made of a material having higher wettability to the case 25 than the first insulating layer 26, or a material having lower viscosity than the first insulating layer 26. This makes it possible to reliably seal minute openings of the first case portion 251 and the second case portion 252.

At least a part of the light-emitting element 11 is sealed integrally with the support body 12 and the insulated wires 14a and 14b except for the first surface 111 and the second surface 112 by the first insulating layer 26 from the rear end portion of the first case portion 251 to the front end portion of the second case portion 252. The first surface 111 of the light-emitting element 11 is exposed within the first space 253 formed in the first case portion 251 in the region between the first insulating layer 26 and the second insulating layer 27. The second surface 112 of the light-emitting element 11 is exposed within the second space 254 formed in the second case portion 252 in the region between the first insulating layer 26 and the third insulating layer 28. The first insulating layer 26, the second insulating layer 27, and the third insulating layer 28 are preferably made of a biocompatible insulating resin having high thermal conductivity.

Inside the first case portion 251, the optical component 13 facing the first surface 111 of the light-emitting element 11 is disposed on the support body 12. The optical component 13 causes the light emitted from the light-emitting element 11 to travel to the outside of the first case portion 251. The optical component 13 is a mirror or prism flattened to be thin. As the optical component 13, a meta-polarization element having a thin metasurface element inserted therein may be used. The optical component 13 may be an optical element having a lens function of controlling the divergence angle of the light emitted from the light-emitting element 11. The optical component 13 may include two or more optical elements as described with reference to FIG. 4. For example, the optical component 13 may include the optical element 131 having a lens function of controlling the divergence angle of the light emitted from the light-emitting element 11, and the optical element 132 that reflects, at a predetermined angle, the light whose divergence angle has been controlled by the optical element 131. The optical component 13 is made up of the plurality of optical elements and integrated into a single unit, so that the overall size of the optical component 13 can be reduced, and the light irradiation device 20 can be downsized accordingly.

In FIG. 6, the light emitted from the first surface 111 of the light-emitting element 11 in the + Z direction is emitted in the + Y direction via the optical component 13; however, the direction of light to be emitted is not limited to this example. As long as the light can be emitted to the outside of the first case portion 251 without interfering with the light-emitting element mounting surface 121 of the support body 12 or the second insulating layer 27, the light may be emitted in any direction between the - X direction and the + X direction on the XY plane. In addition, the light may be emitted at an angle inclined in the + Z direction or the - Z direction from the normal line to the light-emitting element mounting surface 121 of the support body 12 as long as the function of the second insulating layer 27 or the light-emitting element 11 is not hindered.

The support body 12 on which the light-emitting element 11 is mounted protrudes outward from at least one of the first case portion 251 or the second case portion 252. In the configuration example of FIG. 6, the support body 12 protrudes from the case 25 on both the tip end side of the first case portion 251 and the rear end side of the second case portion 252. The opening on the tip end side of the first case portion 251 is sealed with the second insulating layer 27 with the support body 12 protruding. The opening on the rear end side of the second case portion 252 is sealed with the third insulating layer 28 with the support body 12 protruding. As illustrated in FIG. 5, the light-emitting element 11 may be arranged between the first support body 12-1 and the second support body 12-2 to improve the heat dissipation property. The first support body 12-1 and the second support body 12-2 may protrude in the + Z direction and the - Z direction from at least one of the first case portion 251 or the second case portion 252. When the first support body 12-1 and the second support body 12-2 protrude from the first case portion 251 toward the + Z side, the direction or angle of the reflective surface of the optical component 13 may be adjusted to extract emitted light in the + X direction or the - X direction.

At least a part of the light-emitting element 11 is integrally sealed together with the support body 12 and the insulated wires 14a and 14b except for the first surface 111 and the second surface 112 by the first insulating layer 26 in the region between the first case portion 251 and the second case portion 252, and is supported by the connecting portion 255. The first insulating layer 26 isolates the electrical connection portion between the light-emitting element 11 and the insulated wire 14a and the electrical connection portion between the light-emitting element 11 and the insulated wire 14b from the coolant 51, and functions as a heat dissipation material through which heat from the light-emitting element 11 is released to the outside. When two-core enameled wires are used as the insulated wires 14a and 14b, the wires are wide wires and allow for double-sided heat dissipation.

The light irradiation device 20 of the second embodiment may be used in combination with an endoscope. The light-emitting element 11 can be used not only as a laser light source for treatment, but also as an illumination light source. In any case, the light irradiation device has a heat dissipation property and an electrical insulation property, and exhibits an effect as a light irradiation device that can be incorporated into a catheter. Unlike an optical fiber, an insulated wire coated with an insulating coating is highly flexible. In addition, the configuration in which the light-emitting element itself is mounted on the support body 12 offers high integration, and has a wide range of applications for sensors.

### Third Embodiment

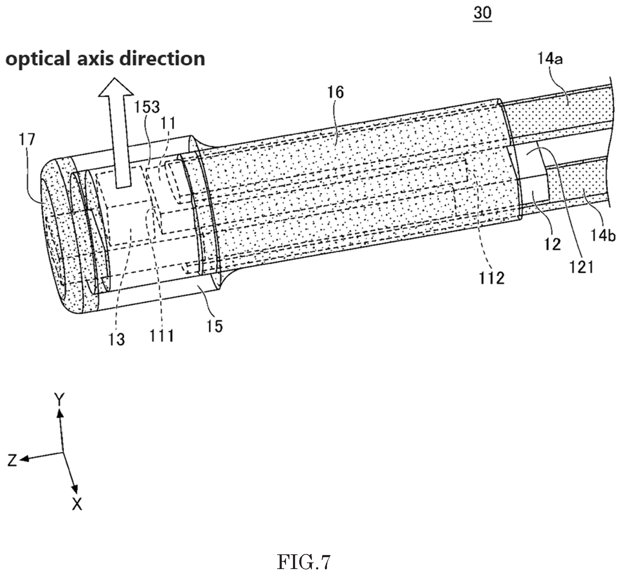

FIG. 7 is a schematic view of a light irradiation device 30 of the third embodiment. In the third embodiment, only the region including the first surface 111 of the light-emitting element 11 is accommodated in the case 15, and the portion extending from the case 15 in the - Z direction is sealed with an insulating resin. Similarly to the first and second embodiments, the light irradiation device 30 is inserted into the catheter 50 (see FIG. 1), and can be used while being cooled by the coolant 51. The light irradiation device 30 includes the light-emitting element 11 having the first surface 111 from which light having a predetermined wavelength is emitted, the support body 12 on which the light-emitting element 11 is mounted, the first insulating layer 16 covering at least a part of the light-emitting element 11 except for the first surface 111, the insulated wires 14a and 14b electrically connected to the light-emitting element 11 in a region excluding the first surface 111, and the case 15 sealing the first surface 111 within the first space 153.

The first insulating layer 16 seals the rear end portion (- Z side) of the case 15, and integrally covers at least a part of the light-emitting element 11 except for the first surface 111, the electrical connection portion between the light-emitting element 11 and the insulated wire 14a and the electrical connection portion between the light-emitting element 11 and the insulated wire 14b, and a part of the support body 12 continuously from the rear end portion of the case 15. In the example illustrated in FIG. 7, the first insulating layer 16 covers the second surface 112 on the rear end side of the light-emitting element 11 together with the support body 12 and the insulated wires 14a and 14b. The first insulating layer 16 is preferably an electrically insulating resin having high thermal conductivity. The first insulating layer 16 continuously seals the opening on the rear end side (- Z side) of the case 15 and the layered portion of the support body 12, the light-emitting element 11, and the insulated wires 14a and 14b so that the coolant 51 does not enter the first space 153. The first insulating layer 16 is also in contact with the coolant 51 on its outer surface through which heat from the light-emitting element 11 is released.

The support body 12 protrudes outward from one or both of the case 15 and the first insulating layer 16. The support body 12 protrudes outward from the case 15 and/or the first insulating layer 16, so that the support body 12 can be brought into contact with the coolant 51 to release heat to the outside of the light irradiation device 30.

The light irradiation device 30 includes a second insulating layer 17 sealing the tip end portion (+ Z side) of the case 15. The rear end portion (- Z side) of the case 15 is sealed with the first insulating layer 16 described above. The first insulating layer 16 may be made of an insulating resin material. The second insulating layer 17 may be made of a different type of resin material from that of the first insulating layer 16. For example, the second insulating layer 17 is made of a resin material having higher wettability to the case 15 than the first insulating layer 16, or a resin material having lower viscosity than the first insulating layer 16. The first surface 111 of the light-emitting element 11 is exposed within the first space 153 in the region between the first insulating layer 16 and the second insulating layer 17. The length of the first insulating layer in the Z direction is greater than the length of the second insulating layer in the Z direction. The first insulating layer 16 is applied to cover a relatively wide portion extending from the rear end of the case 15, allowing relatively easy resin sealing. In contrast, the second insulating layer 17 seals, with resin, a minute region, that is, an opening portion at the tip end of the case 15. The viscosity of the second insulating layer 17 is lower than that of the first insulating layer 16, and the opening at the tip end of the case 15 is reliably sealed, thereby preventing the coolant from entering the first space 153.

Preferably, the first insulating layer 16 and the second insulating layer 17 are made of a biocompatible insulating resin having high thermal conductivity. As the resin material, polycarbonate (PC), polyethylene terephthalate (PET), polyimide (PI), polyurethane, polyester imide, or the like, whose components and composition are adjusted to mitigate adverse effects on a biological body, can be used. The first insulating layer 16 and the second insulating layer 17 may be a polysilazane coat. The first insulating layer 16 and the second insulating layer 17 may be made of the same material or different materials. For example, for the second insulating layer 17, a resin having higher viscosity than the resin used for the first insulating layer 16 may be used. When the polysilazane coat is used for the first insulating layer 16, an additional resin having higher viscosity than polysilazane is desirably used to prevent the coolant from entering from the rear end of the case 15. The additional resin may be the same resin as the resin used for the second insulating layer 17, or may be a different resin.

Similarly to the first and second embodiments, the optical component 13 facing the first surface 111 of the light-emitting element 11 is disposed on the support body 12 inside the case 15. The optical component 13 causes light emitted from the light-emitting element 11 to travel to the outside of the case 15. The optical component 13 is a flattened mirror or prism. As the optical component 13, a meta-polarization element having a metasurface element inserted therein may be used, or the optical component 13 may be made up of a plurality of optical elements and integrated into a single unit as described with reference to FIG. 4.

As illustrated in FIG. 5, the light-emitting element 11 may be arranged between the first support body 12-1 and the second support body 12-2 to improve the heat dissipation property. In this case, the first support body 12-1 and the second support body 12-2 may protrude in the + Z or - Z direction from at least one of the first case portion 251 or the second case portion 252. When the first support body 12-1 and the second support body 12-2 protrude from the case 15 toward the + Z side, the direction or the angle of the reflective surface of the optical component 13 may be adjusted to extract emitted light in the + X direction or the - X direction.

The configuration of the third embodiment can further reduce the size of the light irradiation device 30, and facilitates insertion of the light irradiation device 30 into the catheter 50. In addition, the entire region of the light-emitting element 11 excluding the first surface 111 is sealed with the first insulating layer 16, and the support body 12 and the insulated wires 14a and 14b are extended outward of the first insulating layer 16, so that the heat dissipation property can be improved.

### Industrial Applicability

The present invention can be used not only for a light irradiation device inserted into a medical catheter, but also for other medical applications. The present invention is also applicable to a sensor or the like that requires local light irradiation in combination with a coolant.

Embodiments of the present disclosure can include, for example, the following configurations.
[Aspect 1] A light irradiation device comprising: a light-emitting element having a first surface from which light having a predetermined wavelength is emitted; a support body on which the light-emitting element is mounted; a first insulating layer covering at least a part of the light-emitting element except for the first surface; an insulated wire electrically connected to the light-emitting element in a region excluding the first surface; and a case in which the first surface is sealed within a first space.
[Aspect 2] The light irradiation device according to Aspect 1, wherein the first insulating layer seals a rear end portion of the case, and integrally covers, continuously from the rear end portion of the case, an electrical connection portion between the light-emitting element and the insulated wire, and a part of the support body, and at least a part of the light-emitting element except for the first surface.
[Aspect 3] The light irradiation device according to Aspect 1 or 2, wherein the support body protrudes outward from one or both of the case and the first insulating layer.
[Aspect 4] The light irradiation device according to any one of Aspects 1 to 3, comprising a second insulating layer sealing a tip end portion of the case, wherein the first insulating layer is an insulating resin sealing the rear end portion of the case, and the second insulating layer is made of a resin material different from a resin material of the first insulating layer.
[Aspect 5] The light irradiation device according to Aspect 1, wherein the case comprises a first case portion in which the first surface of the light-emitting element is sealed within the first space, and a second case portion in which a second surface of the light-emitting element is sealed within a second space, the second surface being on a side opposite to the first surface, and in a region between the first case portion and the second case portion, the first insulating layer integrally covers an electrical connection portion between the light-emitting element and the insulated wire, a part of the support body, and at least a part of the light-emitting element except for the first surface and the second surface.
[Aspect 6] The light irradiation device according to Aspect 5, comprising: a second insulating layer sealing a tip end portion of the first case portion; and a third insulating layer sealing a rear end portion of the second case portion.
[Aspect 7] The light irradiation device according to Aspect 6, wherein a rear end portion of the first case portion is sealed with the first insulating layer, and in the region between the first insulating layer and the second insulating layer, the first surface of the light-emitting element is exposed within the first space.
[Aspect 8] The light irradiation device according to Aspect 6, wherein a tip end portion of the second case portion is sealed with the first insulating layer, and in the region between the first insulating layer and the third insulating layer, the second surface of the light-emitting element is exposed within the second space.
[Aspect 9] The light irradiation device according to Aspect 6, wherein the second insulating layer and the third insulating layer are made of a material different from a material of the first insulating layer.
[Aspect 10] The light irradiation device according to Aspect 5, wherein the case comprises a connecting portion connecting the first case portion and the second case portion, and at least a part of the light-emitting element, an electrical connection portion between the light-emitting element and the insulated wire, and a part of the support body are integrally covered by the first insulating layer and supported by the connecting portion.
[Aspect 11] The light irradiation device according to Aspect 5, wherein the support body protrudes outward from at least one of the first case portion or the second case portion.
[Aspect 12] The light irradiation device according to any one of Aspects 1 to 11, comprising an optical component disposed inside the first space, and configured to cause the light emitted from the first surface of the light-emitting element to travel to an outside of the case.
[Aspect 13] An in-vivo light irradiation assembly comprising: a catheter; and the light irradiation device according to any one of Aspects 1 to 12, the light irradiation device being inserted into the catheter, wherein an inside of the catheter is filled with a coolant at least during use.

This application claims priority based on Japanese Patent Application No. 2023-211660, filed with the Japan Patent Office on December 15, 2023, the entire contents of which are included herein by reference.

### Reference Characters List

10, 10A, 10B, 20 Light irradiation device
11 Light-emitting element
111 First surface
112 Second surface
12, 12-1, 12-2 Support body
121 Light-emitting element mounting surface
122 Back surface
124 Conductive film
13 Optical component
14a, 14b Insulated wire
15, 25 Case
15-1, 251 First case portion
15-2, 252 Second case portion
16, 26 First insulating layer
17, 27 Second insulating layer
18, 28 Third insulating layer
50 Catheter
51 Coolant
153, 253 First space
154, 254 Second space
255 Connecting portion

## Claims

1. A light irradiation device comprising:
a light-emitting element having a first surface from which light having a predetermined wavelength is emitted;
a support body on which the light-emitting element is mounted;
a first insulating layer covering at least a part of the light-emitting element except for the first surface;
an insulated wire electrically connected to the light-emitting element in a region excluding the first surface; and
a case in which the first surface is sealed within a first space.

2. The light irradiation device according to claim 1, wherein the first insulating layer seals a rear end portion of the case, and integrally covers, continuously from the rear end portion of the case, an electrical connection portion between the light-emitting element and the insulated wire, and a part of the support body, and at least a part of the light-emitting element except for the first surface.

3. The light irradiation device according to claim 1, wherein the support body protrudes outward from one or both of the case and the first insulating layer.

4. The light irradiation device according to any one of claims 1 to 3, comprising
a second insulating layer sealing a tip end portion of the case, wherein
the first insulating layer is an insulating resin sealing the rear end portion of the case, and
the second insulating layer is made of a resin material different from a resin material of the first insulating layer.

5. The light irradiation device according to claim 1, wherein
the case comprises
a first case portion in which the first surface of the light-emitting element is sealed within the first space, and
a second case portion in which a second surface of the light-emitting element is sealed within a second space, the second surface being on a side opposite to the first surface, and
in a region between the first case portion and the second case portion, the first insulating layer integrally covers an electrical connection portion between the light-emitting element and the insulated wire, a part of the support body, and at least a part of the light-emitting element except for the first surface and the second surface.

6. The light irradiation device according to claim 5, comprising:
a second insulating layer sealing a tip end portion of the first case portion; and
a third insulating layer sealing a rear end portion of the second case portion.

7. The light irradiation device according to claim 6, wherein
a rear end portion of the first case portion is sealed with the first insulating layer, and
in the region between the first insulating layer and the second insulating layer, the first surface of the light-emitting element is exposed within the first space.

8. The light irradiation device according to claim 6, wherein a tip end portion of the second case portion is sealed with the first insulating layer, and
in the region between the first insulating layer and the third insulating layer, the second surface of the light-emitting element is exposed within the second space.

9. The light irradiation device according to claim 6, wherein the second insulating layer and the third insulating layer are made of a material different from a material of the first insulating layer.

10. The light irradiation device according to claim 5, wherein the case comprises a connecting portion connecting the first case portion and the second case portion, and
at least a part of the light-emitting element, an electrical connection portion between the light-emitting element and the insulated wire, and a part of the support body are integrally covered by the first insulating layer and supported by the connecting portion.

11. The light irradiation device according to claim 5, wherein the support body protrudes outward from at least one of the first case portion or the second case portion.

12. The light irradiation device according to any one of claims 1 to 11, comprising
an optical component disposed inside the first space, and configured to cause the light emitted from the first surface of the light-emitting element to travel to an outside of the case.

13. An in-vivo light irradiation assembly comprising:
a catheter; and
the light irradiation device according to any one of claims 1 to 12, the light irradiation device being inserted into the catheter,
wherein an inside of the catheter is filled with a coolant at least during use.
